# EUROPÄISCHE PATENTSCHRIFT

(11) **EP 2 483 895 B1**
(45) Veröffentlichungstag und Bekanntmachung des Hinweises auf die Patenterteilung: **07.05.2014**
(21) Anmeldenummer: 10763663.1
(22) Anmeldetag: 29.09.2010
(51) Int. Cl.: H01B 12/00, H01B 12/02, H01B 12/08, H01B 13/12, H01B 13/14, H01B 13/16, H01B 13/18

(54) **VERFAHREN ZUM AUFBRINGEN VON KUNSTSTOFF AUF EINZELLEITER UND HTS-VERBUND HERGESTELLT AUS DEN EINZELLEITERN**
PROCESS FOR THE DEPOSITION OF PLASTIC MATERIAL ONTO A SINGLE CONDUCTOR AND HTS COMPOSITE PRODUCED THEREFROM
PROCÉDÉ POUR RECOUVRIR UN CONDUCTEUR D'UNE MATIERE PLASTIQUE ET UN ASSEMBLAGE HTS PRODUIT DE CES PIECES

(30) Priorität: 30.09.2009 DE 102009047865
(43) Veröffentlichungstag der Anmeldung: 08.08.2012
(73) Patentinhaber: Siemens Aktiengesellschaft, 80333 München (DE)
(72) Erfinder: ARNDT, Tabea, 91056 Erlangen (DE)
(86) Internationale Anmeldenummer: PCT/EP2010/064473
(87) Internationale Veröffentlichungsnummer: WO 2011/039265

(56) Entgegenhaltungen:
- EP-A1- 1 273 015
- RODNEY ALAN BADCOCK: "Progress in manufacture of long length YBCO Roebel cables", IEEE TRANSACTIONS ON APPLIED SUPERCONDUCTIVITY, Bd. 19, Nr. 3, 3. Juni 2009 (2009-06-03), Seiten 3244-3247, XP002616699,

## Beschreibung

Die vorliegende Erfindung bezieht sich auf ein Verfahren zum Aufbringen eines Kunststoffes auf wenigstens einen Einzelleiter eines Hochtemperatur-Supraleiter (HTS)-Verbundes nach Art eines Roebel-Leiters und auf einen Hochtemperatur-Supraleiter (HTS)-Verbund hergestellt mit dem Verfahren, wobei der wenigstens eine Einzelleiter wenigstens einen Träger und wenigstens eine supraleitende Schicht umfasst.

Roebel-Leiter werden häufig in der Energietechnik eingesetzt, da die "Verdrillung" bzw. "Verseilung" der einzelnen elektrischen Leiter untereinander zu geringeren elektrischen Verlusten bei einem Stromfluss durch den gesamten Roebel-Leiter führen. Bei einer Reihe von Anwendungen werden die RoebelLeiter wechselnden magnetischen Feldern ausgesetzt. Dabei werden in den einzelnen elektrischen Leitern Kopplungsströme induziert, welche zu sogenannten AC-Verlusten beitragen. Die Kopplungsströme können verhindert werden, indem die einzelnen elektrischen Leiter gegeneinander isoliert sind.

Bei konventionellen Roebel-Verbundleitern, welche zum Beispiel aus Kupfer oder Aluminium bestehen, werden für die Isolation in der Regel konventionelle Isolationslacke verwendet. Eine Übertragung der Verfahren zur Isolation von konventionellen Roebel-Verbundleitern auf Hochtemperatur-Supraleiter (HTS)-Verbünde nach Art eines Roebel-Leiters ist nur eingeschränkt bzw. nicht möglich. Zum Einen umfassen in der Regel Hochtemperatur-Supraleiter (HTS)-Verbünde einzelne elektrische Leiter in Bandform, wobei die Bänder hohe Aspektverhältnisse aufweisen. So sind z.B. typische Aspektverhältnisse Breite zu Dicke bei Bi-Cuprat-HTS-Bändern größer oder gleich 10 und bei YBCO-(Yttrium-Barium-Kupferoxid)Bändern größer gleich 20. Dadurch kommt es bei konventionellen Isolationsla"Hundeknochenbildung", mit stark inhomogener Wandstärke der Isolation über den Bandumfang.

Zum Anderen müssen die Isolationsmaterialien bei Temperaturen von kleiner 110°K einsetzbar sein, ohne spröde oder brüchig zu werden. Typische HTS-Materialien weisen erst ab Temperaturen unterhalb 110°K ihre Sprungtemperatur auf, d.h. supraleitende Eigenschaften. Nur hochwertige Kunststoffe verspröden oder verlieren ihre mechanische Integrität bei diesen niedrigen Temperaturen nicht. Somit können zur Isolation nur hochwertige Kunststoffe verwendet werden.

Es ist weiterhin zu beachten, dass die Wandstärke der Isolation die sogenannte Ingenieursstromdichte, welche den kritischen Strom bzw. den Betriebsstrom dividiert durch den Leitungsquerschnitt wiedergibt, verringert. Geringe Wandstärken der Isolation sind somit von Vorteil. Bei konventionellen Lackisolationen kann die Wandstärke auf Grund der Kantenflucht nur begrenzt minimiert werden.

Im Artikel "Progress in the manufacture of long length YBCO Roebel cables" von R. Badcock et al. in IEEE Transactions on applied superconductivity, vol. 19, No. 3, S. 3244-3247 wird ein Roebelleiter aus keramischem Hochtemperatursupraleiter beschrieben, bei dem die einzelnen Stränge mittels einer aufgerollten und anschließend unter UV-Licht vernetzten Polymerschicht isoliert werden. Die so erhaltene Isolationschicht ist etwa 20 µm dick.

Bei S-förmigen Wechselzonen von Roebel-Einzelleitern ist eine Isolation vor der Ausformung der S-Form nur dann möglich, wenn die Isolation elastische Eigenschaften aufweist. Hochtemperatur-Supraleiter sind in der Regel aus keramischen Werkstoffen aufgebaut, d.h. sie sind spröde. Nur wenn der Hochtemperatur-Supraleiter eine plastische Biegung erlaubt ohne zu brechen, wie es z.B. bei Bi-Cuprat-HTS-Bändern der Fall ist, kann eine Isolation vor Ausformung der S-Zone erfolgen. Bei YBCO-Hochtemperatur-Supraleitern muss die S-Zone durch Herausstanzen des Einzelleiters aus einem breiteren Band geformt werden. Eine Isolation ist erst nach dem Stanzen sinnvoll.

Eine einfache Methode der Isolation stellt das einfache oder zweifache Umwickeln der Roebel-Einzelleiter mit selbstklebendem Kapton-Band dar. Das Kapton-Band selbst weist in der Regel eine Dicke im Bereich von größer 13µm auf. Durch die Klebstoffschicht und einen nötigen Überlapp folgt ein Dickenauftrag pro Seite des Einzelleiters durch die Umwicklung von größer 30 µm. Eine Umwicklungstechnik mit Kapton-Band führt zu verminderten Gleiteigenschaften der Einzelleiter insbesondere untereinander. Dies ergibt eine verminderte Flexibilität bzw. Biegsamkeit des Leiterverbundes, zusammengesetzt aus Einzelleitern. Die Umwicklungstechnik ist nicht anwendbar für Einzelleiter mit bereits ausgeformter S-Zonen Form.

Eine weitere Methode der Isolation ist auf Basis von Polyamid möglich. Der notwendige Überlapp führt in diesem Fall zu einem Dickenzuwachs durch die Isolation pro Seite des Einzelleiters von größer 50 µm.

Alternativ kann eine Isolation durch Koextrusion von PEEK (*Polyetheretherketon*) in Schlauchform erflogen. Dies ist z.B. aus der EP 1 273 015 B1 bekannt. Durch diese Methode wird eine gleichmäßige Isolation der Einzelleiter auch über die Schmalseiten der HTS-Bänder erzielt. Der Dickenzuwachs pro Seite beträgt 20 bis 40 µm. Diese Technik hat sich auch bei HTS-Roebel-Verbundleitern auf Basis von Bi-Cupraten bewährt. Allerdings ist sie nicht geeignet für eine Isolation von HTS-Roebel-Verbundleitern auf der Basis von YBCO-Material, bei welchen die S-Zonen-Formung bereits vor der Isolation erfolgt ist.

Aufgabe des erfindungsgemäßen Verfahrens zum Aufbringen eines Kunststoffes auf wenigstens einen Einzelleiter eines Hochtemperatur-Supraleiter (HTS)-Verbundes nach Art eines Roebel-Leiters ist es, eine einfache Methode der Isolation der Einzelleiter anzugeben, welche die Ausbildung einer sehr dünnen Isolationsschicht ermöglicht. Insbesondere ist es eine Aufgabe des erfindungsgemäßen Verfahren eine Methode anzugeben, welche die supraleitenden Eigenschaften der Einzelleiter beim Aufbringen einer Isolation verbessert oder zumindest nicht bzw. nur geringfügig verschlechtert.

Eine weitere Aufgabe ist es ein Verfahren zur Isolation der Einzelleiter anzugeben, bei welcher die Einzelleiter zusammengesetzt zu einem biegsamen, flexiblen Leiterverbund führen. Aufgabe eines erfindungsgemäßen Hochtemperatur-Supraleiter (HTS)-Verbundes nach Art eines Roebel-Leiters ist einen stabilen, mechanisch flexiblen supraleitenden Leiterverbund anzugeben, welcher auch bei tiefen Temperaturen seine mechanische Integrität, insbesondere in Hinblick auf die Isolierung der Einzelleiter bewahrt.

Die angegebene Aufgabe wird bezüglich des Verfahrens zum Aufbringen eines Kunststoffes auf wenigstens einen Einzelleiter eines Hochtemperatur-Supraleiter (HTS)-Verbundes nach Art eines Roebel-Leiters mit den Merkmalen des Anspruchs 1 und bezüglich des Hochtemperatur-Supraleiter (HTS)-Verbundes nach Art eines Roebel-Leiters, hergestellt mit dem zuvor genannten Verfahren mit den Merkmalen des Anspruchs 12 gelöst.

Vorteilhafte Ausgestaltungen des erfindungsgemäßen Verfahrens zum Aufbringen eines Kunststoffes auf wenigstens einen Einzelleiter eines Hochtemperatur-Supraleiter (HTS)-Verbundes nach Art eines Roebel-Leiters und des Hochtemperatur-Supraleiter (HTS)-Verbundes, gehen aus den jeweils zugeordneten abhängigen Unteransprüchen hervor. Dabei können die Merkmale des Hauptanspruchs mit Merkmalen der Unteransprüche und/oder Merkmale von Unteransprüchen untereinander kombiniert werden.

Bei dem erfindungsgemäßen Verfahren zum Aufbringen eines Kunststoffes auf wenigstens einen Einzelleiter eines Hochtemperatur-Supraleiter (HTS)-Verbundes nach Art eines Roebel-Leiters umfasst der wenigstens eine Einzelleiter wenigstens einen Träger und wenigstens eine supraleitende Schicht. Es werden Partikel auf den wenigstens einen Einzelleiter aufgebracht und darauffolgend erfolgt eine thermische Behandlung.

Das Aufbringen von Partikeln und die anschließende thermische Behandlung führen zur Ausbildung einer elektrisch isolierenden Kunststoffschicht auf dem wenigstens einen Einzelleiter. Gleichzeitig erfolgt eine Verbesserung der supraleitenden Eigenschaften der supraleitenden Schicht durch die thermische Behandlung. Die Hafteigenschaften der supraleitenden Schicht auf dem wenigstens einen Träger des Einzelleiters werden durch die thermische Behandlung verbessert. Es bildet sich eine glatte, auch bei tiefen Temperaturen mechanisch stabile, nicht spröde Isolationsschicht auf dem wenigstens einen Träger und der wenigstens einen supraleitenden Schicht aus.

Die Partikel können durch thermisches Spritzen und/oder durch ein Dispersionsverfahren und/oder durch ein Verfahren basierend auf elektrostatischen Wechselwirkungen aufgebracht werden.

Die thermische Behandlung kann in einem Temperaturbereich von 100°C bis 500°C, insbesondere in einem Temperaturbereich von 120°C bis 430°C, durchgeführt werden. Bei diesen Temperaturen werden die Partikel aufgeschmolzen und verbinden sich mechanisch bei einem anschließenden Abkühlen untereinander und mit der Oberfläche des wenigstens einen Trägers und/oder der wenigstens einen supraleitenden Schicht stabil. In dem angegebenen Temperaturbereich erfolgt ein Ausglühen der wenigstens einen supraleitenden Schicht, wobei sowohl die kristalline Struktur der supraleitenden Schicht verbessert wird, und damit die supraleitenden Eigenschaften bei tiefen Temperaturen, als auch die Hafteigenschaften der supraleitenden Schicht auf dem Träger verbessert werden.

Auf den wenigstens einen Einzelleiter können im Wesentlichen Partikel aufgebracht werden, welche einen Durchmesser im Bereich kleiner 10 µm aufweisen. Dadurch kann eine Kunststoffschicht ausgebildet werden, welche eine Dicke im Bereich von kleiner 20 µm aufweist.

Die Partikel können teilweise oder vollständig aus einem thermoplastischen Kunststoff, insbesondere aus PEEK (*Polyetheretherketon*)- oder PEEEK- oder PEEKEK- oder PEKK-Material, aufgebaut werden oder diesen umfassen bzw. daraus teilweise oder vollständig bestehen. Diese Materialien führen zu keiner Versprödung der Isolation bei tiefen Temperaturen, insbesondere nicht bei Betriebstemperaturen von supraleitenden Einrichtungen. Sie sind elektrisch isolierend und sowohl zeitlich als auch mechanisch stabil. Sie können glatte Oberflächen ausbilden mit guten Gleiteigenschaften. Ihre Schmelztemperatur liegt im Bereich von 300 bis 500°C und somit im angegebenen Temperaturbereich der thermischen Behandlung.

Bei der thermischen Behandlung kann ein Trägermedium aus dem Kunststoff entfernt werden. So kann insbesondere bei Dispersionsmethoden zum Aufbringen der Kunststoffschicht ein Trägermedium, in welchem sich die Partikel als Dispersion befinden, bei der thermischen Behandlung aus- bzw. verdampfen. Nach Verdampfen des Trägermediums bildet sich eine glatte, mechanisch stabile Isolationsschicht aus.

Bei der thermischen Behandlung können die Partikel aufgeschmolzen werden und sich untereinander verbinden und/oder sich mit dem wenigstens einen Einzelleiter mechanisch stabil verbinden. Dies ermöglicht eine gute Haftung der Isolationsschicht auf dem Einzelleiter und die Ausbildung einer glatten, nicht porösen, mechanisch stabilen Schicht.

Bei der thermischen Behandlung kann eine Verbesserung der supraleitenden Eigenschaften des Hochtemperatur-Supraleiter (HTS)-Verbundes erfolgen sowie eine Verbesserung der Haftung der wenigstens einen supraleitenden Schicht auf dem Träger. Das Ausglühen des supraleitenden Materials ermöglicht das Ausbilden einer kristallinen Struktur auch über große Bereiche hinweg, wobei Risse und Brüche in der kristallinen, insbesondere einkristallinen Struktur der supraleitenden Schicht verringert werden bzw. verschwinden. Bei hohen Temperaturen erfolgt eine mechanisch stabile Verbindung des supraleitenden Materials mit dem Material eines Trägers bzw. mit Pufferschichten auf dem Trägergrundmaterial. Die verbesserten Eigenschaften der supraleitenden Schichten der Einzelleiter führen zu verbesserten Eigenschaften des Hochtemperatur-Supraleiters (HTS)-Verbundes.

Der Kunststoff kann auf dem wenigstens einen Einzelleiter eine im Wesentlichen glatte, und/oder eine elektrisch isolierende, und/oder eine biegefähige und/oder eine im Wesentlichen gleitfähige Oberfläche ausbilden. Mit Hilfe dieser Eigenschaften der Einzelleiteroberflächen entsteht aus den Einzelleitern ein flexibler, mechanisch stabiler Hochtemperatur-Supraleiter (HTS)-Verbund mit guten supraleitenden und mechanischen, zeitlich stabilen Eigenschaften bei tiefen Temperaturen.

Das Aufbringen des Kunststoffes auf den wenigstens einen Einzelleiter kann vor einer Formgebung des Einzelleiters erfolgen, insbesondere vor einer Ausformung des Einzelleiters in S-Form und/oder insbesondere vor einer Formgebung durch Ausstanzung.

Alternativ kann das Aufbringen des Kunststoffes auf den wenigstens einen Einzelleiter nach einer Formgebung des Einzelleiters erfolgen, insbesondere nach einer Ausformung des Einzelleiters in S-Form und/oder insbesondere nach einer Formgebung durch Ausstanzung.

Ein erfindungsgemäßer Hochtemperatur-Supraleiter (HTS)-Verbund nach Art eines Roebel-Leiters, hergestellt mit dem zuvor beschriebenen Verfahren, ist aus mehreren Einzelleitern zusammengesetzt. Die Einzelleiter umfassen jeweils wenigstens einen Träger und wenigstens eine supraleitende Schicht sowie eine auf dem wenigstens einen Träger und/oder der wenigstens einen supraleitenden Schicht ausgebildete Kunststoffschicht. Die Einzelleiter sind derart ineinander gesteckt, dass ein Roebel-Leiter ausgebildet ist und benachbarte, aufeinanderfolgende Einzelleiter jeweils an ihren Enden elektrisch kontaktiert sind über Kontaktbereiche sowie restliche Bereiche der Oberfläche der Einzelleiter jeweils mit der Kunststoffschicht belegt und elektrisch von benachbarten Einzelleitern isoliert sind.

Die Kunststoffschicht eines Einzelleiters kann eine maximale Dicke im Bereich kleiner 10 µm aufweisen. Dadurch ist eine hohe "Ingenieursstromstärke", d.h. ein hoher kritischer Strom möglich. Ein Kantenfluch, wie sie bei konventioneller Lackisolation auftritt, ist nicht bzw. verringert ausgebildet. Die Kunststoffschicht ist auch bei Temperaturen unterhalb der Sprungtemperatur der supraleitenden Schicht einsetzbar, d.h. sie versprödet bei diesen Temperaturen nicht und ermöglicht ein gleiten der Einzelleiter untereinander, wodurch der Hochtemperatur-Supraleiter (HTS)-Verbund biegsam und flexibel ist.

Für den erfindungsgemäßen Hochtemperatur-Supraleiter (HTS)-Verbund nach Art eines Roebel-Leiters, hergestellt mit dem zuvor beschriebenen Verfahren, ergeben sich die vorstehend erwähnten, mit dem erfindungsgemäßen Verfahren zum Aufbringen eines Kunststoffes auf wenigstens einen Einzelleiter eines Hochtemperatur-Supraleiter (HTS)-Verbundes nach Art eines Roebel-Leiters verbundenen Vorteile.

Bevorzugte Ausführungsformen der Erfindung mit vorteilhaften Weiterbildungen gemäß den Merkmalen der abhängigen Ansprüche werden nachfolgend anhand der folgenden Figuren näher erläutert, ohne jedoch darauf beschränkt zu sein.

Es zeigen:
- Fig. 1: ein Flussdiagramm eines Prozesses zur Kunststoffbeschichtung eines Einzelleiters eines Hochtemperatur-Supraleiter (HTS)-Verbundes mit Partikeln, und
- Fig. 2: ein Flussdiagramm eines Dispersionsprozesses zur Kunststoffbeschichtung des Einzelleiters mit Partikeln, und
- Fig. 3: einen Einzelleiter, beschichtet mit Partikeln entsprechend dem Verfahren der Fig. 1 vor einem Prozessschritt Schmelzglühen, und
- Fig. 4: einen Einzelleiter, beschichtet mit Partikeln entsprechend dem Verfahren der Fig. 1 nach einem Prozessschritt Schmelzglühen, und
- Fig. 5: einen Einzelleiter, beschichtet mit Partikeln entsprechend dem Verfahren der Fig. 2 vor einem Prozessschritt Trockenglühen, und
- Fig. 6: einen Einzelleiter, beschichtet mit Partikeln entsprechend dem Verfahren der Fig. 2 nach einem Prozessschritt Trockenglühen, und
- Fig. 7: einen Einzelleiter, beschichtet mit Partikeln entsprechend dem Verfahren der Fig. 2 nach einem Prozessschritt Schmelzglühen.

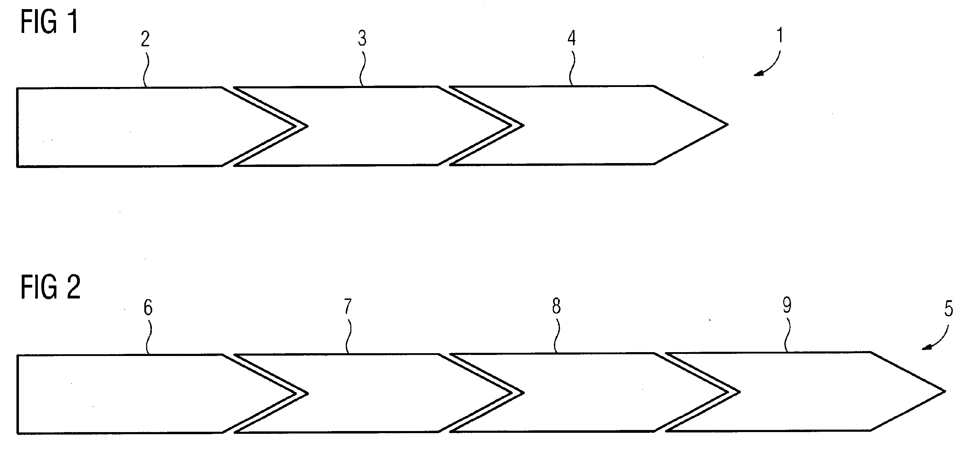

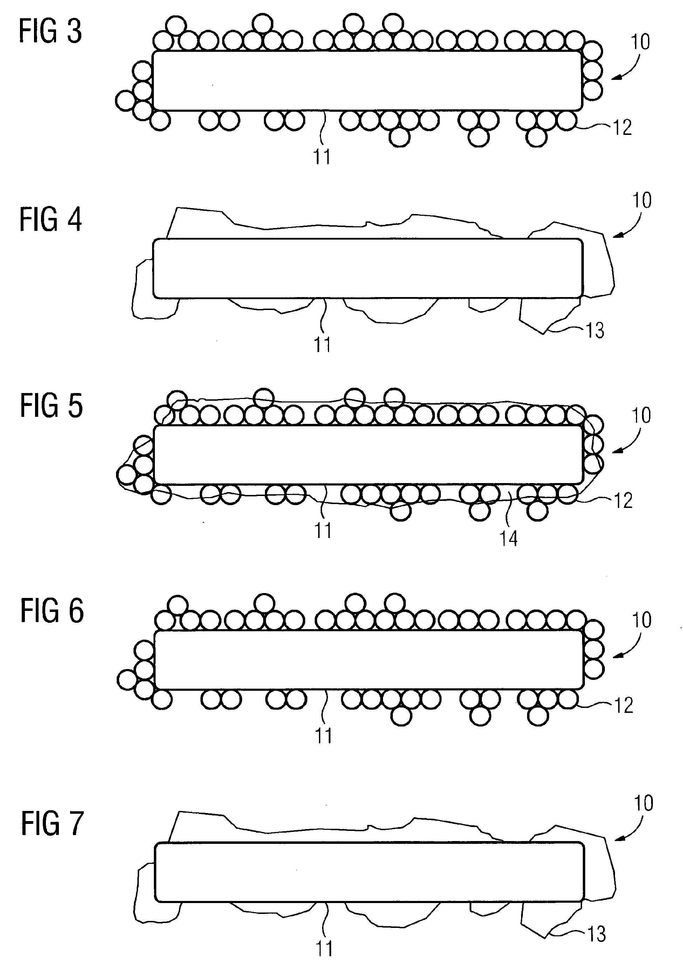

In Fig. 1 ist ein Prozessschema 1 zur Partikelbeschichtung eines Einzelleiters 10 mit "trocknen" Partikeln aus Kunststoff 12 dargestellt. In den Fig. 3 und 4 ist entsprechend der Einzelleiter 10 nach einzelnen Prozessschritten dargestellt. Der Einzelleiter 10 umfasst einen Träger 11 mit wenigstens einer supraleitenden Schicht. Der Träger besteht z.B. aus Stahl. Die Schicht kann z.B. aus YBCO-Material aufgebaut sein und als dünne Beschichtung auf einer Oberfläche einer oder mehreren Seiten des Trägers 11 ausgebildet sein. Zur besseren Haftung der supraleitenden Schicht können zwischen der Oberfläche des Trägers 11 und der darauf befindlichen supraleitenden Schicht eine oder mehrere Pufferschichten angeordnet sein.

Die Partikel 12 zur Beschichtung des Einzelleiters 10 mit Kunststoff werden in dem in Fig. 1 dargestellten Verfahren in einem ersten Schritt mittels elektrostatischer Beschichtung oder mittels Pulverbeschichtung auf den Einzelleiter 10 aufgebracht. Anschließend werden die beschichteten Einzelleiter 10 in einem Durchlaufofen einer thermischen Behandlung 3, dem sogenannten Schmelzglühen bei einer Temperatur von z.B. 430°C ausgesetzt. Dabei schmelzen die Partikel 12 an ihrer Oberfläche oder vollständig auf und verbinden sich mit benachbarten Partikeln 12 und/oder der Oberfläche des Einzelleiters 10. In einem anschließenden Schritt des Verfahrens 1 werden die beschichteten Einzelleiter 10 abgekühlt auf Umgebungstemperatur, z.B. mit Hilfe einer Druckluftstrecke 4.

Als Ergebnis des Verfahrens 1 entsteht ein mit Kunststoff beschichteter Einzelleiter 10, wie er z.B. in Fig. 4 dargestellt ist. Die Kunststoffschicht 13 kann den Träger 11 und/oder die supraleitende Schicht vollständig umschließen oder wie in Fig. 4 dargestellt, nur bestimmte Bereiche des Trägers 11 oder der supraleitenden Schicht bedecken.

Ein alternatives Verfahren 5 zur Beschichtung des Einzelleiters 10 ist in Fig. 2 dargestellt. In den Figuren 5, 6 und 7 ist der Einzelleiter 10 nach verschiedenen Prozessschritten des Verfahrens 5 dargestellt. Als Ausgangspunkt für das in Fig. 2 dargestellte Verfahren dient, analog dem Verfahren der Fig. 1, ein Träger 11 mit supraleitender Schicht sowie fakultativ mit zwischen dem Träger 11 und der supraleitenden Schicht angeordneter Pufferschicht oder angeordneten Pufferschichten.

Auf den Träger 11 und/oder der supraleitenden Schicht, welche der Einfachheit halber in den Fig. 3 bis 7 nicht dargestellt ist, wird eine Dispersion aufgebracht 6, umfassend Partikel 11 aus Kunststoff und ein Trägermedium 14. Das Aufbringen der Dispersion 6 kann mittels Sprühdüsen oder direktem Düsenauftrag erfolgen. In einem anschließenden Prozessschritt werden die beschichteten Einzelleiter 10 z.B. in einem Durchlaufofen bei etwa 120°C einem Trockenglühen 7 unterzogen. Wie in Fig. 6 dargestellt, ist als Ergebnis das Trägermedium 14 der Partikel 12 verdampft und die Partikel 12 befinden sich im Wesentlichen in einem "trockenen" Zustand auf dem Träger 11 mit der supraleitenden Schicht. In einem anschließenden Prozessschritt kann, analog dem in Fig. 1 gezeigten Prozess, ein Schmelzglühen 8 bei einer Temperatur im Bereich zwischen 120°C und 430°C erfolgen. Die Partikel 12 werden dabei teilweise oder vollständig aufgeschmolzen und verbinden sich untereinander und/oder mit der Oberfläche des Einzelleiters 10, d.h. mit der Oberfläche des Trägers 11 und/oder mit der Oberfläche der supraleitenden Schicht. Anschließend können die Einzelleiter 10 in einer Druckluftstrecke 9 auf Umgebungstemperatur abgekühlt werden. Dabei bildet sich eine geschlossene oder offene Schicht 13 aus Kunststoff auf dem Träger 11 mit supraleitender Schicht aus, wie sie in Fig. dargestellt ist.

Mehrer Einzelleiter 10 können nach der Beschichtung mit Partikeln 12 nach dem Verfahren der Fig. 1 oder 2 verwendet werden, um einen Hochtemperatur-Supraleiter (HTS)-Verbund nach Art eines Roebel-Leiters herzustellen. Dabei werden die Einzelleiter 10 entweder vor der Beschichtung in S-Form gebracht oder nach der Beschichtung aus einem beschichteten Band in S-Form gestanzt bzw. durch Laserbearbeitung herausgeschnitten. Die beschichteten Einzelleiter 10 werden ineinander gesteckt, um eine "verdrillte" Leiterstruktur, den sogenannten Roebel-Leiter zu erhalten. An den Enden sind die Einzelleiter 10 nur teilweise oder nicht beschichtet, um einen elektrischen Kontakt hintereinander angeordneter Einzelleiter untereinander zu ermöglichen. Benachbarte, nicht hintereinander angeordnete Einzelleiter 10 sind über die Kunststoffschicht 13 gegeneinander elektrisch isoliert.

Als Material für die Kunststoffschicht 13 kann PEEK verwendet werden. Es sind aber auch andere Materialien möglich, abhängig von den in den Prozessen verwendeten Temperaturen.

## Patentansprüche

1. Verfahren zum Aufbringen eines Kunststoffes (1, 5) auf wenigstens einen Einzelleiter (10) eines Hochtemperatur-Supraleiter (HTS)-Verbundes nach Art eines Roebel-Leiters, wobei der wenigstens eine Einzelleiter (10) wenigstens einen Träger (11) und wenigstens eine supraleitende Schicht umfasst, **dadurch gekennzeichnet, dass** Partikel (12) auf den wenigstens einen Einzelleiter (10) aufgebracht (2, 6) werden und darauf folgend eine thermische Behandlung (3, 7, 8) erfolgt.

2. Verfahren nach Anspruch 1, **dadurch gekennzeichnet, dass** die Partikel (12) durch thermisches Spritzen und/oder durch ein Dispersionsverfahren (6) und/oder durch ein Verfahren basierend auf elektrostatischen Wechselwirkungen (2) aufgebracht werden.

3. Verfahren nach einem der Ansprüche 1 oder 2, **dadurch gekennzeichnet, dass** die thermische Behandlung (3, 7, 8) in einem Temperaturbereich von 100°C bis 500°C, insbesondere in einem Temperaturbereich von 120°C bis 430°C, durchgeführt wird.

4. Verfahren nach einem der vorhergehenden Ansprüche, **dadurch gekennzeichnet, dass** auf den wenigstens einen Einzelleiter (10) im Wesentlichen Partikel (12) aufgebracht werden, welche einen Durchmesser im Bereich kleiner 10 µm aufweisen, und/oder eine Kunststoffschicht (13) durch die aufgebrachten Partikeln ausgebildet wird, welche eine Dicke im Bereich von kleiner 20 µm aufweist.

5. Verfahren nach einem der vorhergehenden Ansprüche, **dadurch gekennzeichnet, dass** die Partikel (12) teilweise oder vollständig aus einem thermoplastischen Kunststoff, insbesondere aus PEEK (*Polyetheretherketon*)- oder PEEEK- oder PEEKEK- oder PEKK-Material, aufgebaut werden.

6. Verfahren nach einem der vorhergehenden Ansprüche, **dadurch gekennzeichnet, dass** bei der thermischen Behandlung (7) ein Trägermedium aus dem Kunststoff entfernt wird.

7. Verfahren nach einem der vorhergehenden Ansprüche, **dadurch gekennzeichnet, dass** bei der thermischen Behandlung (3, 8) die Partikel aufgeschmolzen werden und sich untereinander verbinden und/oder sich mit dem wenigstens einen Einzelleiter mechanisch stabil verbinden.

8. Verfahren nach einem der vorhergehenden Ansprüche, **dadurch gekennzeichnet, dass** durch die thermische Behandlung (3, 7, 8) eine Verbesserung der supraleitenden Eigenschaften des Hochtemperatur-Supraleiter (HTS)-Verbundes erfolgt und/oder eine Verbesserung der Haftung der wenigstens einen supraleitenden Schicht auf dem Träger (11) erfolgt.

9. Verfahren nach einem der vorhergehenden Ansprüche, **dadurch gekennzeichnet, dass** der Kunststoff auf dem wenigstens einen Einzelleiter (10) eine im Wesentlichen glatte, und/oder eine elektrisch isolierende, und/oder eine biegefähige und/oder eine im Wesentlichen gleitfähige Oberfläche ausbildet.

10. Verfahren nach einem der vorhergehenden Ansprüche, **dadurch gekennzeichnet, dass** das Aufbringen des Kunststoffes (2, 6) auf den wenigstens einen Einzelleiter vor einer Formgebung des Einzelleiters (10) erfolgt, insbesondere vor einer Ausformung des Einzelleiters (10) in S-Form und/oder insbesondere vor einer Formgebung durch Ausstanzung.

11. Verfahren nach einem der Ansprüche 1 bis 9, **dadurch gekennzeichnet, dass** das Aufbringen des Kunststoffes (2, 6) auf den wenigstens einen Einzelleiter nach einer Formgebung des Einzelleiters erfolgt, insbesondere nach einer Ausformung des Einzelleiters in S-Form und/oder insbesondere nach einer Formgebung durch Ausstanzung.

12. Hochtemperatur-Supraleiter (HTS)-Verbund nach Art eines Roebel-Leiters, hergestellt mit einem Verfahren nach einem der Ansprüche 1 bis 11, wobei der Hochtemperatur-Supraleiter (HTS)-Verbund aus mehreren Einzelleitern (10) zusammengesetzt ist, welche jeweils wenigstens einen Träger (11) und wenigstens eine supraleitende Schicht sowie eine auf dem wenigstens einen Träger (11) und/oder der wenigstens einen supraleitenden Schicht ausgebildeten Kunststoffschicht (13) umfassen, wobei Einzelleiter (10) derart ineinander gesteckt sind, dass ein Roebel-Leiter ausgebildet ist und benachbarte, aufeinanderfolgende Einzelleiter (10) jeweils an ihren Enden elektrisch kontaktiert sind über Kontaktbereiche sowie restliche Bereiche der Oberfläche der Einzelleiter (10) jeweils mit der Kunststoffschicht (13) belegt und elektrisch von benachbarten Einzelleitern (10) isoliert sind, **dadurch gekennzeichnet, dass** die auf einem Einzelleiter (10) aufgebrachte elektrisch isolierende Kunststoffschicht (13) aus aufgebrachten und geschmolzenen Partikeln besteht.

13. Hochtemperatur-Supraleiter (HTS)-Verbund nach Anspruch 12, **dadurch gekennzeichnet, dass** jeweils die Kunststoffschicht (13) eines Einzelleiters (10) eine maximale Dicke im Bereich kleiner 10 µm aufweist.

## Claims

1. Method for applying a plastic material (1, 5) onto at least one individual conductor (10) of a high-temperature superconductor (HTS) cable in the form of a Roebel conductor, the at least one individual conductor (10) comprising at least one support (11) and at least one superconducting layer, **characterized in that** particles (12) are applied (2, 6) onto the at least one individual conductor (10) and a heat treatment (3, 7, 8) is then carried out.

2. Method according to Claim 1, **characterized in that** the particles (12) are applied by thermal spraying and/or by a dispersion method (6) and/or by a method based on electrostatic interactions (2).

3. Method according to Claim 1 or 2, **characterized in that** the heat treatment (3, 7, 8) is carried out in a temperature range of from 100°C to 500°C, particularly in a temperature range of from 120°C to 430°C.

4. Method according to one of the preceding claims, **characterized in that** particles (12) which have a diameter in the range of less than 10 µm are essentially applied onto the at least one individual conductor (10), and/or a plastic material layer (13) which has a thickness in the range of less than 20 µm is formed by the applied particles.

5. Method according to one of the preceding claims, **characterized in that** the particles (12) are partially or fully formed from a thermoplastic material, in particular from PEEK (*polyether ether ketone*) material or PEEEK material or PEEKEK material or PEKK material.

6. Method according to one of the preceding claims, **characterized in that** a carrier medium is removed from the plastic material during the heat treatment (7).

7. Method according to one of the preceding claims, **characterized in that** during the heat treatment (3, 8), the particles are melted and bond to one another and/or bond in a mechanically stable fashion to the at least one individual conductor.

8. Method according to one of the preceding claims, **characterized in that** as a result of the heat treatment (3, 7, 8), an improvement of the superconducting properties of the high-temperature superconductor (HTS) cable takes place and/or an improvement of the adhesion of the at least one superconducting layer on the support (11) takes place.

9. Method according to one of the preceding claims, **characterized in that** the plastic material forms an essentially smooth and/or electrically insulating and/or bendable and/or essentially slideable surface on the at least one individual conductor (10).

10. Method according to one of the preceding claims, **characterized in that** the application of the plastic material (2, 6) onto the at least one individual conductor takes place before shaping the individual conductor (10), in particular before shaping the individual conductor (10) in an S-shape and/or in particular before shaping by punching.

11. Method according to one of Claims 1 to 9, **characterized in that** the application of the plastic material (2, 6) onto the at least one individual conductor takes place after shaping the individual conductor, in particular after shaping the individual conductor in an S-shape and/or in particular after shaping by punching.

12. High-temperature superconductor (HTS) cable in the form of a Roebel conductor, produced by a method according to one of Claims 1 to 11, the high-temperature superconductor (HTS) cable being composed of a plurality of individual conductors (10) which respectively comprise at least one support (11) and at least one superconducting layer as well as a plastic material layer (13) formed on the at least one support (11) and/or on the at least one superconducting layer, individual conductors (10) being interlaced with one another so that a Roebel conductor is formed, successive neighboring individual conductors (10) respectively being electrically contacted via contact regions at their ends, and remaining regions of the surface of the individual conductors (10) respectively being coated with the plastic material layer (13) and electrically insulated from neighboring individual conductors (10), **characterized in that** the electrically insulating plastic material layer (13) applied on an individual conductor (10) consists of applied and molten particles.

13. High-temperature superconductor (HTS) cable according to Claim 12, **characterized in that** the plastic material layer (13) of an individual conductor (10) respectively has a maximum thickness in the range of less than 10 µm.

## Revendications

1. Procédé de dépôt d'une matière ( 1, 5 ) plastique sur au moins un conducteur ( 10 ) individuel d'un composite de supraconducteur à haute température ( HTS ) à la manière d'un conducteur de Roebel, dans lequel le au moins un conducteur ( 10 ) individuel comprend au moins un support ( 11 ) et au moins une couche supraconductrice,
**caractérisé en ce que** l'on dépose ( 2, 6 ) des particules ( 12 ) sur le au moins un conducteur ( 10 ) individuel et ensuite on effectue un traitement ( 3, 7, 8 ) thermique.

2. Procédé suivant la revendication 1, **caractérisé en ce que** l'on dépose les particules ( 12 ) par projection thermique et/ou par un procédé ( 6 ) de dispersion et/ou par un procédé reposant sur des interactions ( 2 ) électrostatiques.

3. Procédé suivant l'une des revendications 1 ou 2, **caractérisé en ce que** l'on effectue le traitement ( 3, 7, 8 ) thermique dans une plage de température allant de 100°C à 500°C, notamment dans une plage de température allant de 120°C à 430°C.

4. Procédé suivant l'une des revendications précédentes, **caractérisé en ce que** l'on dépose sur le au moins un conducteur ( 10 ) individuel essentiellement des particules ( 12 ) qui ont un diamètre dans la plage de plus petit que 10 µm et/ou on forme une couche ( 13 ) de matière plastique par les particules déposées qui a une épaisseur dans la plage de plus petit que 20 µm.

5. Procédé suivant l'une des revendications précédentes, **caractérisé en ce que** l'on forme les particules ( 12 ) en tout ou partie en une matière plastique thermoplastique, notamment en PEEK ( polyétheréthercétone ) ou en PEEEK ou en PEEKEK ou en PEKK.

6. Procédé suivant l'une des revendications précédentes, **caractérisé en ce que**, lors du traitement ( 7 ) thermique, on élimine un milieu support de la matière plastique.

7. Procédé suivant l'une des revendications précédentes, **caractérisé en ce que** lors du traitement ( 3, 8 ) thermique, on fait fondre les particules et on les relie entre elles et/ou on les relie d'une manière stable mécaniquement au au moins un conducteur individuel.

8. Procédé suivant l'une des revendications précédentes, **caractérisé en ce que**, par le traitement ( 3, 7, 8 ) thermique, il se produit une amélioration des propriétés supraconductrices du composé de supraconducteur à haute température ( SHT ) et/ou il se produit une amélioration de l'adhérence de la au moins une couche supraconductrice au support ( 11 ).

9. Procédé suivant l'une des revendications précédentes, **caractérisé en ce que** la matière plastique forme sur le au moins un conducteur ( 10 ) individuel une surface sensiblement lisse et/ou isolante du point de vue électrique et/ou susceptible de se plier et/ou sensiblement apte à glisser.

10. Procédé suivant l'une des revendications précédentes, **caractérisé en ce que** l'on effectue le dépôt de la matière ( 2, 6 ) plastique sur le au moins un conducteur individuel avant un façonnage du conducteur ( 10 ) individuel, notamment avant de mettre le conducteur ( 10 ) individuel sous une forme S et/ou notamment avant un façonnage par poinçonnage.

11. Procédé suivant l'une des revendications 1 à 9, **caractérisé en ce que** l'on effectue le dépôt de la matière ( 2, 6 ) plastique sur le au moins un conducteur individuel après un façonnage du conducteur individuel, notamment après une mise du conducteur individuel sous la forme S et/ou notamment après un façonnage par poinçonnage.

12. Composite de supraconducteur à haute température ( SHT ) à la manière d'un conducteur de Roebel, fabriqué par un procédé suivant l'une des revendications 1 à 11, dans lequel le composite de supraconducteur à haute température ( SHT ) est composé de plusieurs conducteurs ( 10 ) individuels qui comprennent respectivement au moins un support ( 11 ) et au moins une couche supraconductrice, ainsi qu'une couche ( 13 ) de matière plastique formée sur le au moins un support ( 11 ) et/ou sur la au moins une couche supraconductrice, des conducteurs ( 10 ) individuels étant enfilés les uns dans les autres de manière à former un conducteur de Roebel et des conducteurs ( 10 ) individuels successifs et voisins étant en contact électriquement respectivement à leurs extrémités par des parties de contact tandis que des parties restantes de la surface des conducteurs ( 10 ) individuels sont occupées respectivement par la couche ( 13 ) de matière plastique et sont isolées électriquement de conducteurs ( 10 ) individuels voisins, **caractérisé en ce que** la couche ( 13 ) de matière plastique isolante du point de vue électrique et déposée sur un conducteur ( 10 ) individuel est constituée de particules déposées et fondues.

13. Composite de supraconducteur à haute température ( SHT ) suivant la revendication 12, **caractérisé en ce que** chaque couche ( 13 ) de matière plastique d'un conducteur individuel a une épaisseur maximum dans la plage plus petite que 10 pm.
